Europäisches Patentamt

European Patent Office

Office européen des brevets

(11) Publication number: **0 159 786**
**B1**

(12) EUROPEAN PATENT SPECIFICATION

(45) Date of publication of patent specification: 02.11.88  (51) Int. Cl.⁴: **G 01 R 19/10,** G 01 R 27/26

(21) Application number: 85301562.6

(22) Date of filing: 07.03.85

(54) Improvements in the measurement of impedance ratios.

(30) Priority: 09.03.84 GB 8406160

(43) Date of publication of application:
30.10.85 Bulletin 85/44

(45) Publication of the grant of the patent:
02.11.88 Bulletin 88/44

(84) Designated Contracting States:
DE FR

(56) References cited:
GB-A-2 036 982
US-A-4 187 459

(73) Proprietor: **AUTOMATIC SYSTEMS
LABORATORIES LIMITED**
**Breckland Saxon Street Linford Wood**
**Milton Keynes Buckinghamshire MK14 6LD (GB)**

(72) Inventor: **Daykin, Christopher Israel**
**12 Bideford Court Linslade**
**Leighton Buzzard Bedfordshire (GB)**
Inventor: **Yewen, John David**
**31 Regent Street**
**Leighton Buzzard Bedfordshire (GB)**
Inventor: **Wolfendale, Peter Caleb Frederick**
**33 Pound Hill Great Brickhill**
**Milton Keynes Buckinghamshire MK17 9AS (GB)**

(74) Representative: **Cole, Paul Gilbert et al**
**Hughes Clark Byrne & Parker 63 Lincoln's Inn
Fields P.O. Box 22**
**London WC2A 3JU (GB)**

Courier Press, Leamington Spa, England.

## Description

This invention relates to apparatus for measuring the ratio of two electrical impedances that provides an output that is readily digitised. It is particularly, but not exclusively, intended for providing a digitised output representing the setting of a capacitance transducer that may be used for a variety of purposes eg. measuring strain, displacement, pressure, load or level.

Our UK Patent No. 2036982 describes and claims electrical apparatus for measuring the ratio of first and second impedance means $C_1$, $C_2$ each connected at one side to an input to a first direct current amplifier that outputs an error signal, means for supplying a repetitive waveform synchronously to the other side of the first and second impedance means, a detector driven synchronously with the waveform supplied to said impedance means and fed with the error signal of the first direct current amplifier to generate a direct current output in response thereto, a second direct current amplifier arranged as an integrator and fed with the output of the detector to output a voltage $V_2$ that determines the amplitude of the waveform fed to one of said first and second impedance means, the amplitude of the waveform fed to the other of said impedance means being determined by a reference voltage $V_1$, the arrangement being such that the circuit reaches a balance so that $V_2/V_1 = C_2/C_1$. In that apparatus the voltage $V_2$ fed to one of the impedances is derived by means of a feedback loop that includes the demodulator and integrator and is arranged so that the voltage at the summing junction of the first direct current amplifier is always zero by reason of the high loop gain of the feedback circuit.

It is an object of this invention to provide a ratiometric circuit for measuring a variable impedance that provides an output as the ratio of two time periods, thereby facilitating digital representation.

According to the invention apparatus for measuring the ratio of first and second impedances each connected to an input of an amplifier ($A_1$) and including means ($S_1$, $S_2$) for applying repetitive waveforms at a constant frequency to the first and second impedances ($C_1$, $C_2$) to produce currents at the input of the amplifier which are in antiphase and tend to cancel to result in a resultant current at the input of the amplifier; and in which the amplifier outputs an imbalance signal corresponding to the resultant current, which imbalance signal is used to determine the magnitude of the resultant current; is characterised in that a squarewave generator ($G_2$, $A_3$, $S_4$) generates a squarewave having a mark to space ratio corresponding to the magnitude of the imbalance signal and the squarewave is fed through a low pass filter ($F_1$) to produce a variable amplitude signal which determines the amplitude of the repetitive waveform applied to the second impedance ($C_2$), and in that the mark to space ratio of said squarewave provides a time ratio proportional to the ratio of the first and second impedances.

An embodiment of the invention will now be described by way of example only with reference to the accompanying drawings, in which:

Figure 1 is a circuit diagram of an apparatus for measuring the ratio of two capacitances; and

Figure 2 is a waveform diagram.

In the drawings the impedances to be measured are capacitances $C_1$, $C_2$ one of which is fixed and the other is variable and which form elements of a capacitative transducer. Such transducers operate ratiometrically when one of the elements is fixed and differentially when both are variable, as described, for example, in UK Patent Specification No. 1274856. A voltage $V_1$ from a dc reference source is applied to capacitance $C_1$ through a chopper $S_1$ that comprises a pair of field effect transistor switches driven by a fixed frequency square wave generator G. The second switch is driven from the first switch through an inverter (not shown) and is connected to earth whereby the input to capacitor $C_1$ is grounded when $V_1$ is not applied to $C_1$, the two FET switches being driven in antiphase. The same voltage $V_1$ is applied through switches $S_4$, low pass filter $F_1$ and chopper $S_2$ to one side of capacitor $C_2$. The capacitors $C_1$ and $C_2$ are both connected to the summing junction of operational amplifier $A_1$ having a feedback capacitor $C_3$. Like the chopper $S_1$, the chopper $S_2$ comprises a pair of field effect transistors driven from the square wave generator G in antiphase, one of the switches being earthed so that capacitor $C_2$ is grounded when reference voltage $V_1$ is removed by the carrier generator G. The output from amplifier $A_1$ is fed to switch $S_3$ of a demodulator also driven synchronously from the carrier generator G and the dc output of the demodulator is applied to an integrator constituted by an operational amplifier $A_2$ and feedback elements $R_1$ and $C_4$ that cause the integral of the signal applied via $S_3$ to accumulate at the output of amplifier $A_2$. The integrator is arranged to provide most of the gain of the loop. The amplified dc output from $A_2$ is proportional to the integral of the input signal at $A_1$ and is applied to one input of comparator $A_3$. The other input of the comparator amplifier $A_3$ is driven from a generator $G_2$ of triangular or sawtooth waves which may typically be an integrator circuit driven from generator G via a divider unit $D_1$. Alternatively the generator $G_2$ may be a free-running repetitive ramp waveform generator that may optionally be synchronised to carrier generator G. $D_1$ conveniently divides the frequency output of carrier generator G by a convenient factor eg. 16 where the carrier generator has a frequency of 1600 Hz.

The output from comparator $A_3$ is now a fixed frequency square wave whose mark to space ratio varies between logic 0 and logic 1 depending on the level of the dc voltage $V_2$ at one input compared with the equivalent level of the triangle waveform 10 (Figure 2) at the other input. The output of the comparator $A_3$ is taken to provide a digitisable output and is also used to control the switches $S_4$ which are field effect transistors, again driven in antiphase with one of them earthed. The voltage $V_1$ applied to capacitor $C_2$ is chopped by switches $S_4$ with a variable mark to space ratio so that the average dc voltage level fed to capacitor $C_2$ represents the voltage level needed to drive $C_2$ and produce a zero error voltage at the input of amplifier $A_1$.

In order to reduce the dynamic range of requirements of the amplifier system the output of chopper $S_4$ is smoothed. Therefore the variable mark/space ratio waveform is applied to the low-pass filter $F_1$ which filters out all the ac components of the waveform and leaves only a dc component whose amplitude will be a direct function of the mark/space ratio. This resultant variable dc level is applied to the switch $S_2$ which is driven from the same generator $G_1$ as $S_1$ and therefore applies the same frequency of carrier to $C_2$ but of an amplitude determined by the mark/space ratio. If the voltages are in the correct phase the current through $C_2$ will tend to cancel that due to $C_1$ at the summing junction of the amplifier $A_1$. The system therefore forms a feedback network in which the amplitude driving the capacitor $C_2$ increases until there is no further drive signal at the input of integrator $A_2$ and the balance process has arrived at a steady state.

It will be apparent that in a steady state condition the ratio of the voltage at the input to $S_2$ and the output of filter $F_1$ to the reference voltage $V_1$ represents the ratio of the impedance of the capacitor $C_2$ to the impedance of the capacitor $C_1$. Also the mark to space ratio at the output of comparator $A_3$ also represents the ratio of $C_1$ to $C_2$.

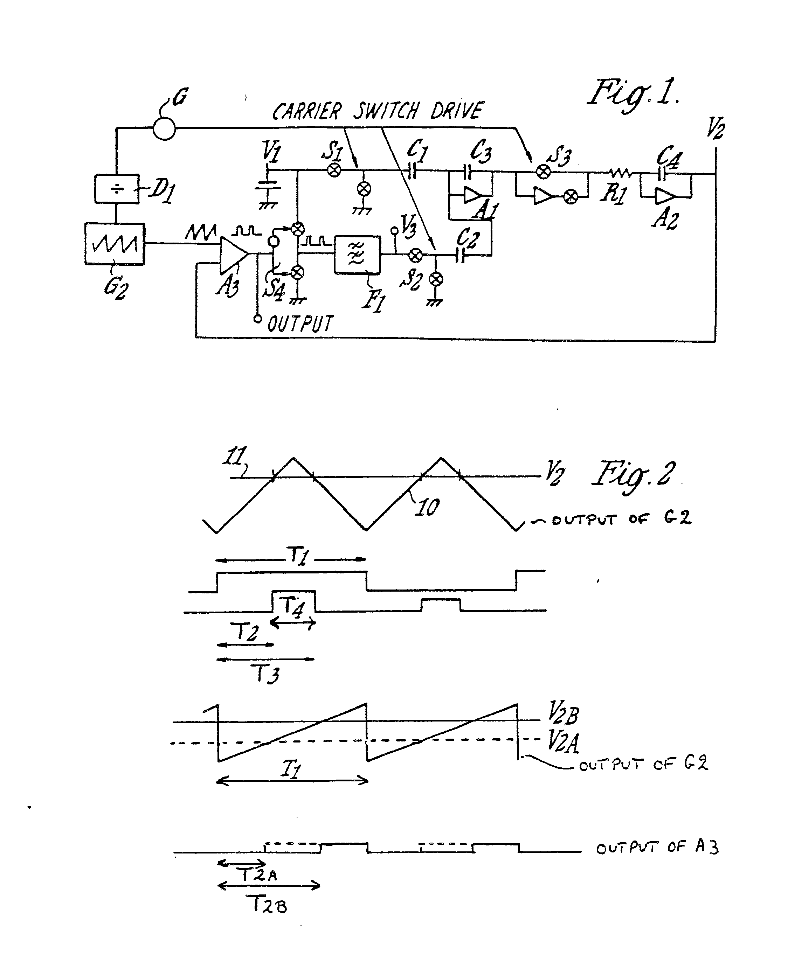

In Figure 2 the waveforms are shown to demonstrate the principles of operation. Waveform 10 is the triangular wave with a period $T_1$ generated by generator $G_2$ which is driven from the divider $D_1$ which in turn is driven from the carrier generator G as shown in Figure 1. Also in Figure 2 line 11 is the dc voltage $V_2$ which occurs at the output of integrator $A_2$ in Figure 1. The amplitude of $V_2$ intersects waveform 10 at an interval of time $T_2$ after the commencement of the triangular waveform and again at $T_3$ on the reverse slope of waveform 10 and the process is repeated at intervals of $T_1$ assuming a steady state condition. It will be apparent that as the amplitude of $V_2$ varies the period $T_3-T_2$ varies also. If $T_3-T_2$ is represented as $T_4$ then the ratio

$$T_4(T_1-T_4)=C_1/C_2.$$

If $T_4$ and $T_1-T_4$ are used to gate a high frequency clock then these time intervals are digitised and may be used to represent the ratio of $C_1$ to $C_2$ in digital form.

Various modifications may be made to the embodiment described above without departing from the invention, whose scope is defined in the appended claims. For example, it is also possible to use a reversible counter to produce the squarewave having a variable mark/space ratio which represents the capacitance ratio. This reversible counter would take the place of integrator $A_2$ and would be used to generate the square waveform applied to filter $F_1$. It will be appreciated that there are a range of possibilities for generating this mark/space ratio square waveform but they all involve representing the capacitance ratio as a time ratio for ease of transmission from a sensor to the outside world. It will also be appreciated that the same technique can be used for other electrical impedances such as resistors or inductors or a combination thereof. The apparatus in accordance with the invention can be implemented in integrated circuit form to provide a compact and accurate interface with an external control system.

**Claims**

1. Apparatus for measuring the ratio of first and second impedances each connected to an input of an amplifier ($A_1$) and including means ($S_1$, $S_2$) for applying repetitive waveforms at a constant frequency to the first and second impedances ($C_1$, $C_2$) to produce currents at the input of the amplifier which are in antiphase and tend to cancel to result in a resultant current at the input of the amplifier; and in which the amplifier outputs an imbalance signal corresponding to the resultant current, which imbalance signal is used to determine the magnitude of the resultant current; characterised in that a squarewave generator ($G_2$, $A_3$, $S_4$) generates a squarewave having a mark to space ratio corresponding to the magnitude of the imbalance signal and the squarewave is fed through a low pass filter ($F_1$) to produce a variable amplitude signal which determines the amplitude of the repetitive waveform applied to the second impedance ($C_2$), and in that the mark to space ratio of said squarewave provides a time ratio proportional to the ratio of the first and second impedances.

2. Apparatus as claimed in claim 1 further characterised in that the squarewave generator ($G_2$, $A_3$, $S_4$) includes a comparator ($A_3$) supplied at one input with the imbalance signal and at another input with triangle or sawtooth waves from a source ($G_2$).

3. Apparatus as claimed in claim 2 further characterised in that the squarewave generator ($G_2$, $A_3$, $S_4$) includes first chopper means ($S_4$) controlled by the comparator and comprising a pair of switches driven in antiphase from the comparator, the switches being connected to two fixed voltages respectively.

4. Apparatus as claimed in claim 3 further characterised in that the means ($S_1$, $S_2$) for applying repetitive waveforms each comprise a pair of switches driven in antiphase, the switches being connected to the two fixed voltages respectively.

5. Apparatus as claimed in claim 3 or 4 further characterised in that one of said fixed voltages is earth.

6. Apparatus as claimed in claim 3, 4 or 5 further characterised in that the switches are field effect transistors.

7. Apparatus as claimed in claim 4, 5 or 6 further characterised in that the source of triangle or sawtooth waves ($G_2$) is driven via a divider ($D_1$) from a carrier generator (G) that also controls the switches of the means ($S_1$, $S_2$) for applying repetitive waveforms.

8. Apparatus as claimed in any preceding claim further characterised in that the first and second impedances ($C_1$, $C_2$) are elements of a capacitative transducer.

## Patentansprüche

1. Vorrichtung zum Messen des Verhältnisses einer ersten und einer zweiten Impedanz, welche beide mit einem Eingang eines Verstärkers ($A_1$) verbunden sind, mit Mitteln ($S_1$, $S_2$) zum Anlegen von sich wiederholenden Wellenformen bei einer konstanten Frequenz an die erste und die zweite Impedanz ($C_1$, $C_2$) zur Erzeugung von Strömen am Eingang des Verstärkers, welche gegenphasig sind und sich derart aufzuheben neigen, daß sich ein resultierender Strom am Eingang des Verstärkers ergibt, wobei der Verstärker ein dem resultierenden Strom entsprechendes Ungleichgewicht—Signal ausgibt, wobei das Ungleichgewicht—Signal zur Bestimmung der Größe des resultierenden Stroms dient, dadurch gekennzeichnet, daß ein Rechteckwellengenerator ($G_2$, $A_3$, $S_4$) eine Rechteckwelle mit einem der Größe des Ungleichgewichts—Signals entsprechenden Tastverhältnis erzeugt, und daß die Rechteckwelle durch einen Tiefpaßfilter ($F_1$) zur Erzeugung einer variablen Amplitude gleitet wird, welche die Amplitude der sich wiederholenden, an die zweite Impedanz ($C_2$) angelegten Wellenformen bestimmt, und daß das Tastverhältnis der Rechteckwelle ein zum Verhältnis der ersten und zweiten Impedanz proportionales Zeitverhältnis aufweist.

2. Vorrichtung nach Anspruch 1, dadurch gekennzeichnet, daß der Rechteckwellengenerator ($G_2$, $A_3$, $S_4$) einen Komparator ($A_3$) aufweist, an dessen einen Eingang das Ungleichgewicht—Signal und an dessen anderen Eingang Dreiecks- oder Sägezahnwellen einer Quelle ($G_2$) angeschlossen sind.

3. Vorrichtung nach Anspruch 2, dadurch gekennzeichnet, daß der Rechteckwellengenerator ($G_2$, $A_3$, $S_4$) einen ersten Zerhacker ($S_4$), welcher durch den Komparator kontrolliert wird, und ein Paar von gegenphasig vom Komparator betriebenen Schaltern aufweist, wobei die Schalter mit zwei festen elektrischen Potentialen verbunden sind.

4. Vorrichtung nach Anspruch 3, dadurch gekennzeichnet, daß die Mittel ($S_1$, $S_2$) zum Anlegen von sich wiederholenden Wellenformen jeweils ein Paar von gegenphasig betriebenen Schaltern aufweisen, wobei die Schalter mit zwei elektrischen Potentialen verbunden sind.

5. Vorrichtung nach Anspruch 3 oder 4, dadurch gekennzeichnet, daß eines der festen Potentiale von der Erde gebildet ist.

6. Vorrichtung nach Anspruch 3, 4 oder 5, dadurch gekennzeichnet, daß die Schalter als Feldsteuerungstransistoren ausgebildet sind.

7. Vorrichtung nach Anspruch 4, 5 oder 6, dadurch gekennzeichnet, daß die Quelle der Dreiecks- oder Sägezahnwellen ($G_2$) über einen Verteiler ($D_1$) von einem Trägergenerator (G) betrieben wird, welcher auch die Schalter der Mittel ($S_1$, $S_2$) zum Anlegen von sich wiederholenden Wellenformen kontrolliert.

8. Vorrichtung nach Anspruch 1 oder einem der folgenden, dadurch gekennzeichnet, daß die erste und die zweite Impedanz ($C_1$, $C_2$) Elemente eines kapazitiven Wandlers sind.

## Revendications

1. Appareil de mesure du rapport d'une première impédance à une seconde impédance branchées chacune à une entrée d'un amplificateur ($A_1$), comprenant des moyens ($S_1$, $S_2$) pour appliquer des formes d'onde répétitives de fréquence constante aux première et seconde impédances ($C_1$, $C_2$) de manière à produire, à l'entrée de l'amplificateur, des courants en opposition de phase tendant à s'annuler pour donner un courant résultant à l'entrée de l'amplificateur, et dans lequel l'amplificateur donne en sortie un signal de déséquilibre correspondant au courant résultant, ce signal de déséquilibre étant utilisé pour déterminer l'amplitude du courant résultant, appareil caractérisé en ce qu'un générateur de forme d'onde carrée ($G_2$, $A_3$, $S_4$) fournit une onde carrée présentant un rapport de la marque à l'espacement qui correspond à l'amplitude du signal de déséquilibre, en ce que l'onde carrée est appliquée par l'intermédiaire d'un filtre passe-bas ($F_1$) pour produire un signal d'amplitude variable déterminant l'amplitude de la forme d'onde répétitive appliquée à la seconde impédance ($C_2$), et en ce que le rapport de la marque à l'espacement de cette onde carrée fournit un rapport de temps proportionnel au rapport de la première à la seconde impédance.

2. Appareil selon la revendication 1, caractérisé en outre en ce que le générateur d'ondes carrées ($G_2$, $A_3$, $S_4$) comprend un comparateur ($A_3$) recevant par l'une de ses entrées le signal de déséquilibre, et par son autre entrée des ondes triangulaires ou en dents de scie provenant d'une source ($G_2$).

3. Appareil selon la revendication 2, caractérisé en outre en ce que le générateur d'ondes carrées ($G_2$, $A_3$, $S_4$) comprend un premier dispositif de découpage ($S_4$) commandé par le comparateur et comprenant une paire de commutateurs commandés en opposition de phase par le comparateur, ces commutateurs étant branchés respectivement à deux tensions fixes.

4. Appareil selon la revendication 3, caractérisé en ce que les moyens ($S_1$, $S_2$) destinés à appliquer les formes d'onde répétitives, comprennent chacun une paire de commutateurs commandés en opposition de phase, ces commutateurs étant branchés respectivement à deux tensions fixes.

5. Appareil selon l'une quelconque des revendications 3 et 4, caractérisé en outre en ce que l'une des tensions fixes est la masse.

6. Appareil selon l'une quelconque des revendications 3, 4 ou 5, caractérisé en outre en ce que les commutateurs sont des transistors à effet de champ.

7. Appareil selon l'une quelconque des revendications 4, 5 ou 6, caractérisé en outre en ce que la source d'ondes triangulaires ou en dents de scie ($G_2$) est commandée, par l'intermédiaire d'un diviseur ($D_1$), par un générateur pilote (G) qui commande également les commutateurs des moyens ($S_1$, $S_2$) destinés à appliquer les formes d'onde répétitives.

8. Appareil selon l'une quelconque des revendications précédentes, caractérisé en outre en ce que les première et seconde impédances ($C_1$, $C_2$) sont des éléments d'un transducteur capacitif.

0 159 786

Fig.1.

CARRIER SWITCH DRIVE

Fig.2.

OUTPUT OF G2

OUTPUT OF G2

OUTPUT OF A3

1